# EUROPÄISCHE PATENTANMELDUNG

(11) **EP 4 238 661 A1**
(43) Veröffentlichungstag der Anmeldung: **06.09.2023**
(21) Anmeldenummer: 23157143.1
(22) Anmeldetag: 17.02.2023
(51) Int. Cl.: B06B 3/00, B29C 65/08, B23K 20/10, H10N 30/88

(54) **KONVERTER**

(30) Priorität: 04.03.2022 DE 102022105131
(71) Anmelder: MS Ultraschall Technologie GmbH, 78549 Spaichingen (DE)
(72) Erfinder: Krell, Volker, 78579 Neuhausen ob Eck (DE)
(74) Vertreter: Manitz Finsterwald Patent- und Rechtsanwaltspartnerschaft mbB

(57) **Zusammenfassung**

Ein Konverter für Ultraschallwerkzeug weist ein Konvertergehäuse aus elektrisch leitendem Material auf, in dem eine mit elektrischen Anschlusskontakten versehene Piezoeinheit vorgesehen ist, die mit einem Schwingkopf aus elektrisch leitendem Material verbunden ist. Die Anschlusskontakte der Piezoeinheit sind elektrisch isoliert.

## Beschreibung

Die vorliegende Erfindung betrifft einen Konverter für ein Ultraschallwerkzeug, umfassend ein Konvertergehäuse aus elektrisch leitendem Material, in dem eine mit elektrischen Anschlusskontakten versehene Piezoeinheit vorgesehen ist, die mit einem Schwingkopf aus elektrisch leitendem Material verbunden ist.

Derartige Ultraschallwerkzeuge dienen zum Verschweißen, Versiegeln, Trennen oder auch Trennschweißen von thermoplastischen Werkstoffen, beispielsweise zum Versiegeln von Materialbahnen. Bei bestimmten Anwendungen kann es erforderlich sein, einen Kontakt zwischen der Sonotrode und einem Amboss, beispielsweise einer rotierenden Walze, zu detektieren. Hierbei können auch mehrere Ultraschallwerkzeuge auf ein und demselben Amboss auftreffen. Um einen mechanischen Kontakt zwischen jeder einzelnen Sonotrode und dem Amboss elektrisch erkennen zu können, muss jedes Ultraschallwerkzeug von dem Amboss elektrisch isoliert sein. Allerdings sind normalerweise derartige Ultraschallwerkzeuge aus Sicherheitsgründen geerdet, was eine elektrische Kontakterkennung verhindert. Ohne eine Erdung des Konvertergehäuses bzw. des Ultraschallwerkzeugs bestünde allerdings die Gefahr eines elektrischen Schlags für Personen, die das Konvertergehäuse oder damit verbundene metallische Komponenten des Ultraschallwerkzeugs berühren.

Es ist deshalb die Aufgabe der vorliegenden Erfindung, ein Ultraschallwerkzeug der eingangs genannten Art zu schaffen, mit dem eine elektrische Kontakterkennung zwischen Ultraschallwerkzeug und einem metallischen Amboss möglich ist.

Die Lösung dieser Aufgabe erfolgt durch die Merkmale des Anspruchs 1 und insbesondere dadurch, dass alle Anschlusskontakte in der Piezoeinheit im Inneren des Konvertergehäuses durch einen elektrischen Isolator gegenüber dem Konvertergehäuse und dem Schwingkopf elektrisch isoliert sind. Durch einen solchen Isolator, der beispielsweise aus einem dielektrischen Feststoff bestehen kann, können sämtliche spannungsführenden Komponenten innerhalb des Konvertergehäuses so isoliert werden, dass auch im Falle eines Kabelbruchs oder eines Bruchs eines Kontaktelementes der Piezoeinheit sichergestellt ist, dass das Konvertergehäuse zu keinem Zeitpunkt unter Spannung steht. In diesem Fall kann in bestimmten Fällen darauf verzichtet werden, das Konvertergehäuse bzw. die damit verbundenen Komponenten wie beispielsweise Sonotrode oder Amplitudenverstärker zu erden, wodurch es möglich ist, an der Sonotrode oder an damit verbundenen Komponenten des Ultraschallwerkzeugs ein elektrisches Signal abzugreifen, das eine Berührung mit einem Amboss erkennen lässt. Dadurch kann an einen Amboss aus elektrisch leitendem Material eine elektrische Signalleitung angeschlossen werden, die zusammen mit einer an dem Ultraschallwerkzeug angeschlossenen Signalleitung ermöglicht, eine Berührung zwischen dem Ultraschallwerkzeug und dem Amboss elektrisch zu detektieren.

Vorteilhafte Ausführungsformen der Erfindung sind in der Beschreibung, der Zeichnung sowie den Unteransprüchen beschrieben.

Nach einer ersten vorteilhaften Ausführungsform kann der Isolator eine physikalische Barriere zwischen allen Anschlusskontakten sowie dem Konvertergehäuse und dem Schwingkopf bilden. Eine solche physikalische Barriere verhindert einerseits nicht nur einen Spannungsüberschlag zwischen stromführenden Komponenten und dem Konvertergehäuse. Vielmehr ist auch ausgeschlossen, dass beispielsweise ein unter Spannung stehendes Kabel von einem Kontakt der Piezoeinheit abbricht und das Konvertergehäuse berührt.

Nach einer weiteren vorteilhaften Ausführungsform kann der Isolator mehrteilig ausgebildet sein, was bei bestimmten Anwendungsfällen die Montage erleichtert und den Materialverbrauch und die damit verbundenen Kosten reduziert.

Nach einer weiteren Vorteilhaften Ausführungsform kann der Isolator eine Hülse und/oder Haube aufweisen. Eine hülsenförmige Ausbildung des Isolators ermöglicht, dass dieser über die üblicherweise zylindrisch ausgebildete Piezoeinheit gestülpt wird. Durch Vorsehen einer Haube lässt sich der Isolator auf besonders einfache und sichere Weise auf die Piezoeinheit aufsetzen und befestigen.

Nach einer weiteren vorteilhaften Ausführungsform kann der Isolator die Piezoeinheit insbesondere vollständig umhüllen, was eine besonders gute Isolierung bewirkt.

Nach einer weiteren vorteilhaften Ausführungsform kann der Isolator eine Vergussmasse aufweisen, beispielsweise ein Elastomer. Hierdurch lässt sich der Raum zwischen der Piezoeinheit und dem Konvertergehäuse, der als zylindrischer Ringraum ausgebildet sein kann, mit einem Isoliermaterial aus Feststoff verfüllen, wodurch die Anschlusskontakte der Piezoeinheit, d.h. die zwischen einzelnen Piezoelementen befindlichen Kontaktscheiben sowie die elektrischen Zuleitungen, in dem Feststoff isoliert und einbettet sind. Sofern als Vergussmasse ein elastisches Material, beispielsweise ein Elastomer, verwendet wird, sind die elektrischen Anschlusskontakte zusätzlich fest und schwingungsgedämpft in der Vergussmasse eingebettet. Durch die am Gehäuse anliegende Feststoffisolierung können dabei zusätzlich unerwünschte Gehäuseschwingungen zusätzlich bedämpft werden.

Nach einer weiteren vorteilhaften Ausführungsform kann zwischen dem Isolator und der Piezoeinheit ein durchströmbarer Ringkanal gebildet sein. Hierdurch ist nicht nur eine elektrische Isolierung geschaffen, sondern auch ein Strömungskanal gebildet, der dazu verwendet werden kann, Kühlluft durch das Konvertergehäuse zu führen, um die Piezoeinheit zu kühlen.

Nach einer weiteren vorteilhaften Ausführungsform kann ein Ringkanal zwischen der Piezoeinheit und dem Konvertergehäuse mit Vergussmasse gefüllt sein, wobei in der Vergussmasse Kühlkanäle gebildet sind. Dies lässt sich beispielsweise dadurch bewerkstelligen, dass vor dem Vergießen kleine Röhren in den Ringkanal eingesetzt werden, die nicht mit Vergussmasse gefüllt werden. Auf diese Weise kann der mit Vergussmasse gefüllte Ringraum durch Hindurchführen von Kühlluft oder Kühlflüssigkeit gekühlt werden.

Wenn der Isolator mit einem oder mehreren Strömungskanälen versehen ist, kann nach einer weiteren vorteilhaften Ausführungsform das Durchführen von Kühlluft optimiert werden.

Nach einer weiteren vorteilhaften Ausführungsform kann der Strömungskanal so geformt sein, dass hindurchströmendes Kühlfluid die Piezoeinheit entlang ihres Außenumfangs umströmt. Hierdurch wird neben der gewünschten elektrischen Isolierung eine besonders gute Kühlung der Piezoeinheit bewirkt.

Nach einer weiteren vorteilhaften Ausführungsform kann der Strömungskanal so geformt sein, dass hindurchströmendes Fluid quer zu einer Schwingungsrichtung der Piezoeinheit auf diese auftrifft. Bei dieser Ausführungsform können beispielsweise Strömungsdüsen vorgesehen sein, welche die hindurchgeführte Kühlluft senkrecht auf die Oberfläche der Piezoeinheit auftreffen lassen, so dass diese besonders gut gekühlt wird.

Nach einer weiteren vorteilhaften Ausführungsform kann der Isolator einen Fluidauslass mit einer Labyrinthdichtung aufweisen, so dass zugeführte Kühlluft auch wieder aus dem durch den Isolator gebildeten Raum austreten kann, ohne dass spannungsführende Teile der Anschlusskontakte von außen berührt werden können oder spannungsführende Komponenten aus dem Konvertergehäuse nach außen gelangen können.

Nach einer weiteren vorteilhaften Ausführungsform kann der Isolator so ausgebildet sein, dass dieser auf die Piezoeinheit aufgesteckt und insbesondere aufgeschnappt bzw. aufgeklipst werden kann, was eine schnelle und einfache Montage begünstigt.

Eine besonders gute Isolation kann dadurch erreicht werden, dass sich der Isolator in Schwingungsrichtung der Piezoeinheit zumindest über deren gesamte Länge erstreckt.

Wenn der Isolator aus elastischem Material hergestellt ist, kann dieser durch Aufstecken oder Aufklipsen fest mit dem Konverter verbunden werden, so dass es im Betrieb nicht zu Vibrationen oder einem Klappern kommt und sich der Isolator nicht von dem Konverter löst.

Nachfolgend wird die vorliegende Erfindung rein beispielhaft anhand verschiedener Ausführungsformen und unter Bezugnahme auf die beigefügten Zeichnungen beschrieben. Es zeigen:
- Fig. 1: einen Längsschnitt durch einen Konverter für ein Ultraschallwerkzeug;
- Fig. 2A bis 2D: verschiedene Ansichten einer ersten Ausführungsform eines Isolators;
- Fig. 3A bis 3D: verschiedene Ansichten einer zweiten Ausführungsform eines Isolators; und
- Fig. 4A bis 4C: verschiedene Ansichten einer dritten Ausführungsform eines Isolators.

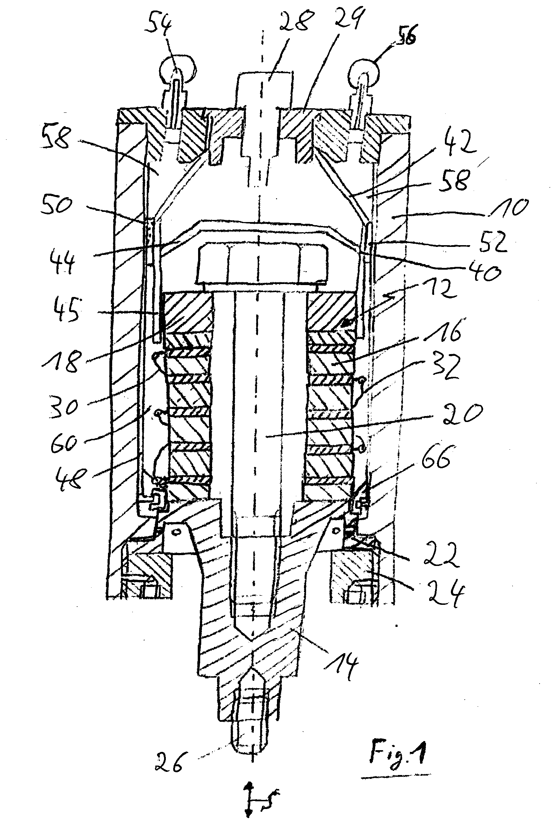

Fig. 1 zeigt einen Längsschnitt durch einen Konverter für ein Ultraschallwerkzeug, der ein Konvertergehäuse 10 aus elektrisch leitendem Material aufweist, in dem eine Piezoeinheit 12 vorgesehen ist, die mit einem Schwingkopf 14 aus elektrisch leitendem Material verbunden ist. Die Piezoeinheit 12 weist dabei auf an sich bekannte Art und Weise einen Stapel von ringförmigen Piezoelementen 16 auf, die mit dem Schwingkopf 14 über einen Haltering 18 mit Hilfe einer Spannschraube 20 verspannt sind. Hierbei ist der Schwingkopf 14 über eine angeformte Membran 22 in dem ebenfalls zylindrischen Konvertergehäuse 10 gehalten, die über einen Spannring 24 in dem Konvertergehäuse 10 befestigt ist. An der Unterseite des Schwingkopfs 14 ist ein Gewindebolzen 26 eingeschraubt, an dem eine weitere Komponente des Ultraschallwerkzeugs befestigt werden kann, beispielsweise ein Amplitudenverstärker oder eine Sonotrode. Die Piezoeinheit 16 ist gegenüber dem Haltering 18 und dem Schwingkopf 14 durch Isolierscheiben elektrisch isoliert.

Die elektrische Ansteuerung der Piezoeinheit 12 erfolgt über einen Steckverbinder 28, der über nicht näher dargestellte elektrische Leitungen mit Anschlusskontakten 30, 32 der Piezoeinheit 12 verbunden ist. Hierbei umfassen die Anschlusskontakte 30, 32 Kontaktscheiben zwischen den einzelnen Piezoelementen 16, die miteinander verbunden sind. Auch umfassen die Anschlusskontakte 32 Leitungen, welche die Kontaktscheiben zwischen den Piezoelementen 16 elektrisch miteinander verbinden. Die elektrischen Zuleitungen von dem Steckverbinder 28 zu den Anschlusskontakten 30, 32 der Piezoeinheit 12 sind zwar isoliert. Jedoch im Bereich der der Anschlusskontakte 30, 32 der Piezoeinheit 12 ist nicht überall eine Isolierung vorhanden, so dass es insbesondere bei einem Kabelbruch oder einem Bruch im Bereich der Kontaktscheiben dazu kommen könnte, dass das elektrisch leitende Konvertergehäuse 10 unter Spannung steht. Um dies zu verhindern, weist der vorstehend beschriebene Konverter einen elektrischen Isolator 40 auf, der sämtliche Anschlusskontakte 30, 32 der Piezoeinheit 12 im Inneren des Konvertergehäuses einerseits gegenüber dem Konvertergehäuse 10 und andererseits gegenüber dem Schwingkopf 14 und gegenüber mit diesem leitend verbundenen Teilen, die von außen berührt werden könnten elektrisch isoliert.

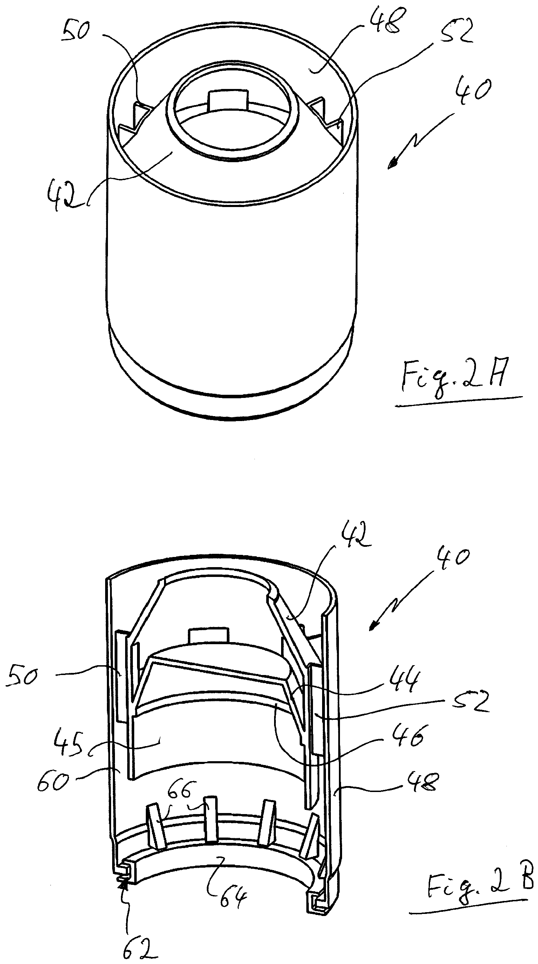

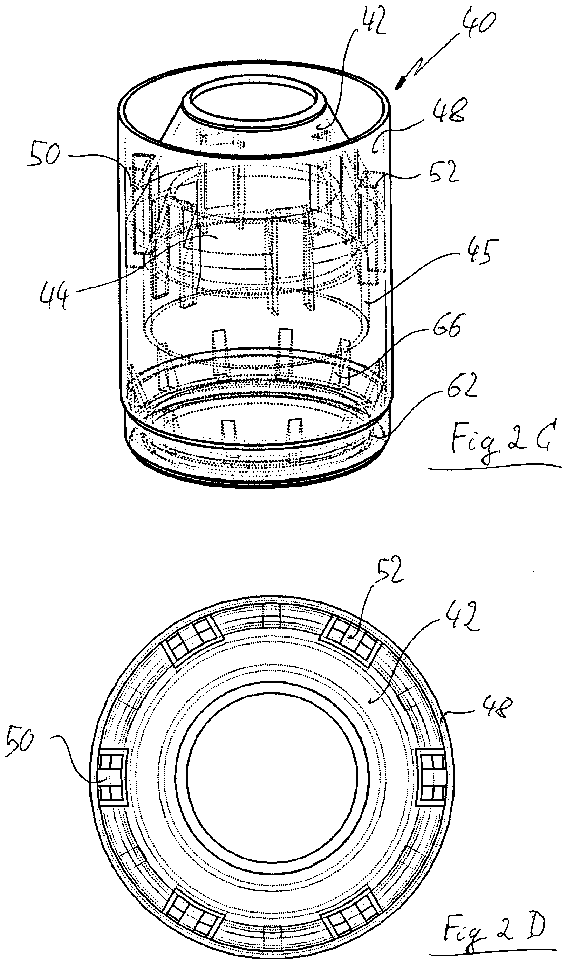

Fig. 1 und Fig. 2A bis Fig. 2D zeigen eine erste Ausführungsform eines solchen Isolators 40, der bei dem dargestellten Ausführungsbeispiel als zylindrische Hülse ausgebildet ist, die in ihrem Inneren zwei ineinander verschachtelte Haubenabschnitte 42 und 44 aufweist. Eine erste, an ihrer Oberseite geschlossene Haube 44 ist so ausgebildet, dass diese über die Spannschraube 20 gesteckt und auf den Haltering 18 klemmend aufgesetzt werden kann. Hierzu ist im Inneren der Haube 44 eine Ringwulst 46 angeformt, die einen Anschlag für den Isolator 40 bildet. Die Haube 44 erstreckt sich an ihrer Unterseite mit ihrem sich an diese anschließenden Zylindermantel 45 bis über den unteren Rand des Halterings 18 hinaus (vgl. Fig. 1), so dass dieser nicht in Kontakt mit elektrisch leitenden Komponenten gelangen kann. Sowohl der Haltering 18 wie auch der Kopf der Spannschraube 20 sind somit von der unteren Haube 44 eingekapselt.

Angeformt an die untere Haube 44 ist eine darüber liegende obere Haube 42, die einen konischen Trichter bildet, der an seiner Oberseite offen ist. Eine Verbindung zwischen den beiden Hauben 42 und 44 und einer zylindrischen Umfangswandung 48 des Isolators 40 erfolgt über mehrere über den Umfang gleich verteilte Stege 50, 52. Da der gesamte Isolator 40 einstückig ausgebildet ist, kann dieser über die Piezoeinheit 12 gestülpt und auf dieser verklemmt werden. Hierbei ist die obere Haube 42 so dimensioniert, dass diese auch im Bereich des Steckverbinders 28 eine physische Barriere zwischen dem Steckverbinder 28 und dem Konvertergehäuse 10 bildet, da die Oberseite der Isolierung 40 an der inneren Unterseite des Konvertergehäuses 10 anliegt.

Wie Fig. 1 verdeutlicht, weist das Konvertergehäuse 10 an seiner Oberseite radial außerhalb von dem Steckverbinder 28 jeweils einen Anschluss 54, 56 für eine Kühlleitung auf. Durch die beiden Anschlüsse 54 und 56 kann Luft parallel zur Schwingungsrichtung S der Piezoeinheit 16 in einen oberen Ringraum 58 eingeführt werden, der zwischen der oberen Haube 42 und der Umfangswand 48 des Isolators 40 gebildet ist, die sich auch bis zur inneren Unterseite des Konvertergehäuses 10 erstreckt. Die zugeführte Luft strömt dann durch einen Ringkanal 60, der zwischen dem Isolator 40 und der Piezoeinheit 16 gebildet ist. Dieser Ringkanal ist in radialer Richtung zur Piezoeinheit 16 hin offen, so dass die durchströmende Kühlluft die Piezoeinheit 16 wirksam kühlt.

Für einen Austritt der durchströmenden Kühlluft ist der Isolator 40 an seiner Unterseite entlang seines Umfangs mit einer Labyrinthdichtung 62 versehen, die durch einen durchströmbaren Ring 64 gebildet ist, der über Stege 66 an die Zylinderwand 48 angeformt ist. Auch könnte die Kühlluft (nur) an der Oberseite des Konverters wieder aus diesem austreten.

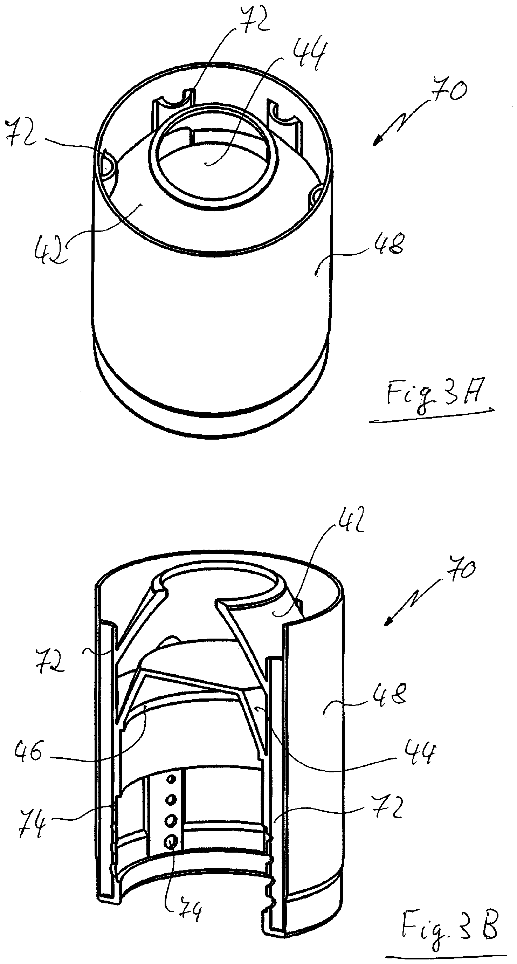

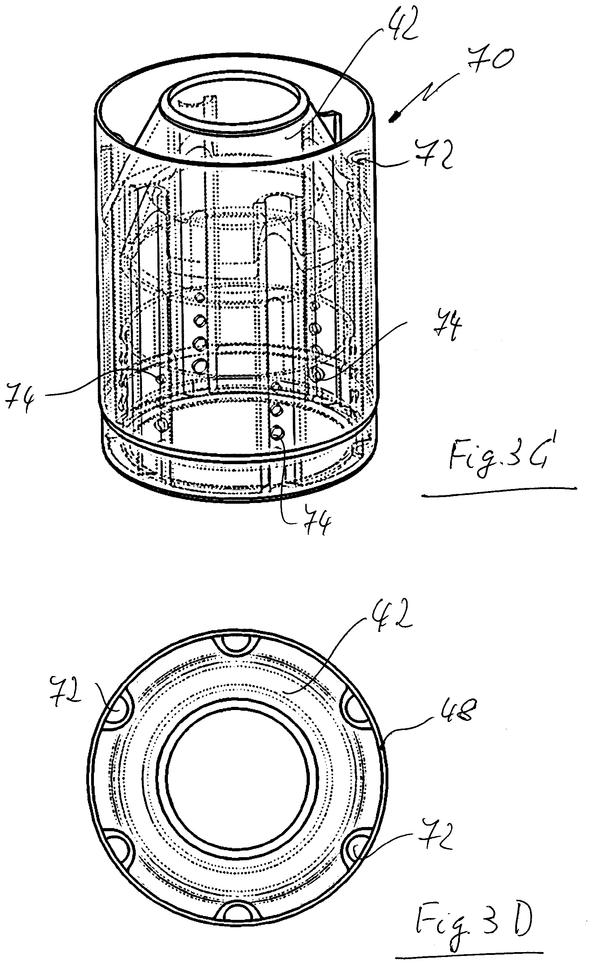

Fig. 3A bis 3D zeigen eine weitere Ausführungsform eines Isolators 70, wobei für gleiche Komponenten gleiche Bezugszeichen verwendet sind. Der Isolator 70 ist ähnlich aufgebaut wie der Isolator 40 und besitzt ebenfalls eine obere, offene Haube 42 und eine darunterliegende untere Haube 44 geschlossen ist. Für die Zuführung von Kühlluft, die durch die Anschlüsse 54 und 56 in das Innere des Konvertergehäuses 10 zugeführt wird, sind bei dieser Ausführungsform an die Innenseite der Zylinderwand 48 rinnenförmige Kühlkanäle 72 angeformt, die an ihrer Oberseite offen sind und sich vom Bereich der oberen Haube 42 bis an das untere Ende des Isolators 70 erstrecken. Im Bereich des unteren Endes der Kühlkanäle 72, d.h. auf der Höhe der Piezoeinheit 16 weist jeder Kühlkanal 72 untereinander angeordnete Strömungsdüsen 74 auf, so dass Luft, die durch den Strömungskanal 72 strömt, durch die Strömungsdüsen 74 aus diesem austritt und quer zur Schwingungsrichtung S der Piezoeinheit 16 auf diese auftrifft. Wie Fig. 3B dabei verdeutlicht, nimmt der Öffnungsquerschnitt jeder Strömungsdüse 74 von der Oberseite des Isolators 70 zu dessen Unterseite hin zu.

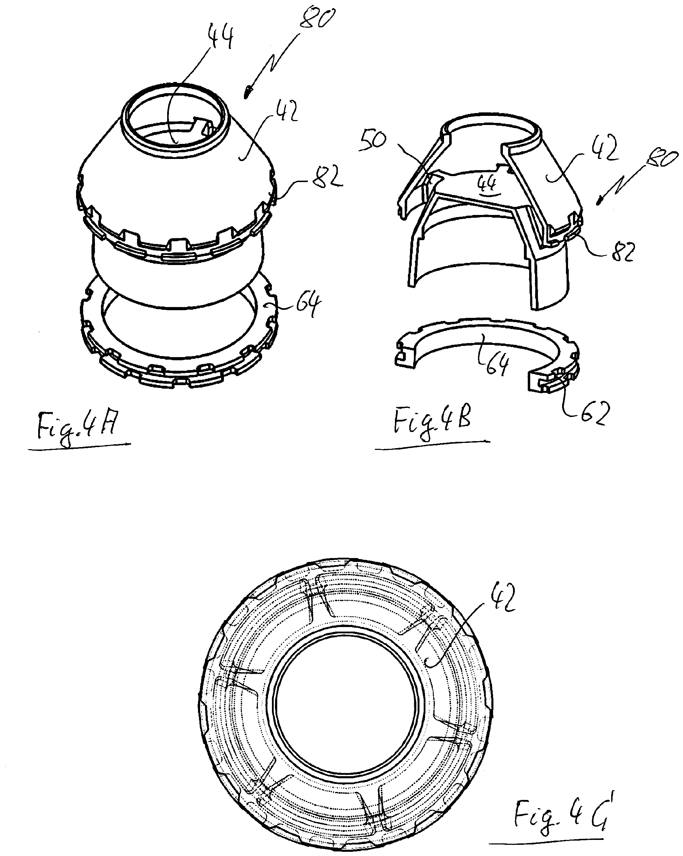

Fig. 4A bis 4C zeigen eine weitere Ausführungsform eines Isolators 80, der ähnlich wie die vorstehend beschriebene Ausführungsform ausgebildet ist, jedoch mehrteilig ausgeführt ist. Gleiche Komponenten sind wiederum mit gleichen Bezugszeichen versehen.

Der Isolator 80 weist wie bei den vorstehend beschriebenen Ausführungsformen eine obere Haube 42 und eine untere Haube 44 auf, die einstückig über mehrere Stege 50 miteinander verbunden sind. Auch ist an der Unterseite des Isolators 80 eine Labyrinthdichtung 62 vorgesehen, die durch einen Ring 64 gebildet ist. Eine Verbindung zwischen dem Ring 64 und den beiden Hauben 42 und 44 wird durch einen nicht dargestellten hülsenförmigen Isoliermantel aus Kunststoff, einer Folie oder Isolierpapier gebildet.

Auch bei dieser Ausführungsform kann Kühlluft über die Anschlüsse 54 und 56 in den Ringraum zwischen der Piezoeinheit 12 und dem Konvertergehäuse 10 einströmen. Dort wird die Luft über Stege 82 entlang des Umfangs oberhalb der Piezoeinheit 16 verteilt, um eine möglichst gut verteilte Strömung zu erzeugen. Die Luft umströmt dann die Piezoeinheit 16 und tritt über die Labyrinthdichtung 62 sowie durch Bohrungen in der Membran 22 des Schwingkopfs 14 wieder aus. Auch hier ist jedoch der Raum, in dem sich spannungsführende Teile der Anschlusskontakte 30, 32 befindet, physikalisch und vollständig von leitenden Bereichen des Konvertergehäuses 10 und des Schwingkopfes 14 getrennt. Für eine weitere Isolation kann der Steckverbinder 28 zur elektrischen Spannungsversorgung in einen isolierenden Einsatz 29 aus Kunststoff eingesetzt sein, was insbesondere vorteilhaft sein kann, wenn der Steckverbinder ein Koaxialsteckverbinder ist.

## Patentansprüche

1. Konverter für ein Ultraschallwerkzeug, umfassend ein Konvertergehäuse (10) aus elektrisch leitendem Material, in dem eine mit elektrischen Anschlusskontakten versehene Piezoeinheit (12) vorgesehen ist, die mit einem Schwingkopf (14) aus elektrisch leitendem Material verbunden ist,
**dadurch gekennzeichnet,**
**dass** alle Anschlusskontakte (30, 32) der Piezoeinheit (12) im Inneren des Konvertergehäuses (10) durch einen elektrischen Isolator (40, 70, 80) gegenüber dem Konvertergehäuse (10) und dem Schwingkopf (14) elektrisch isoliert sind.

2. Konverter nach Anspruch 1,
**dadurch gekennzeichnet,**
**dass** der Isolator (40, 70, 80) eine physische Barriere zwischen allen Anschlusskontakten sowie dem Konvertergehäuse (10) und dem Schwingkopf (14) bildet.

3. Konverter nach Anspruch 1 oder 2,
**dadurch gekennzeichnet,**
**dass** der Isolator (80) mehrteilig ausgebildet ist.

4. Konverter nach einem der vorstehenden Ansprüche,
**dadurch gekennzeichnet,**
**dass** der Isolator (40, 70, 80) eine Hülse (45, 48) und/oder Haube (42, 44) aufweist.

5. Konverter nach einem der vorstehenden Ansprüche,
**dadurch gekennzeichnet,**
**dass** der Isolator (40, 70, 80) die Piezoeinheit (16) umhüllt.

6. Konverter nach einem der vorstehenden Ansprüche,
**dadurch gekennzeichnet,**
**dass** der Isolator (40, 70, 80) aus elastischem Material hergestellt ist und/oder eine Vergussmasse, beispielsweise ein Elastomer, aufweist.

7. Konverter nach einem der vorstehenden Ansprüche,
**dadurch gekennzeichnet,**
**dass** zwischen dem Isolator (40, 70, 80) und der Piezoeinheit (16) ein durchströmbarer Ringkanal (60) gebildet ist.

8. Konverter nach zumindest einem der vorstehenden Ansprüche,
**dadurch gekennzeichnet,**
**dass** ein Ringkanal (60) zwischen der Piezoeinheit (16) und dem Konvertergehäuse (10) mit Vergussmasse gefüllt ist, und dass in der Vergussmasse Kühlkanäle gebildet sind.

9. Konverter nach einem der vorstehenden Ansprüche,
**dadurch gekennzeichnet,**
**dass** der Isolator (40, 70, 80) mit zumindest einem Strömungskanal (60, 72) versehen ist.

10. Konverter nach Anspruch 9,
**dadurch gekennzeichnet,**
**dass** der Strömungskanal (60, 72) so geformt ist, dass hindurchströmendes Fluid die Piezoeinheit (16) entlang ihres Außenumfangs umströmt.

11. Konverter nach einem der vorstehenden Ansprüche 9 oder 10,
**dadurch gekennzeichnet,**
**dass** der Strömungskanal (72) so geformt ist, dass hindurchströmendes Fluid quer zu einer Schwingungsrichtung (S) der Piezoeinheit (16) auf diese auftrifft.

12. Konverter nach einem der vorstehenden Ansprüche,
**dadurch gekennzeichnet,**
**dass** der Isolator (40, 70, 80) einen Fluidauslass mit einer Labyrinthdichtung (62) aufweist.

13. Konverter nach einem der vorstehenden Ansprüche,
**dadurch gekennzeichnet**,
der Isolator (40, 70, 80) auf die Piezoeinheit (16) aufgesteckt, insbesondere aufgeschnappt ist.

14. Konverter nach einem der vorstehenden Ansprüche,
**dadurch gekennzeichnet,**
**dass** sich der der Isolator (40, 70, 80) in Schwingungsrichtung (S) der Piezoeinheit (16) zumindest über deren gesamte Länge erstreckt.

15. Konverter nach einem der vorstehenden Ansprüche,
**dadurch gekennzeichnet,**
**dass** der Isolator (70) Strömungsdüsen (74) aufweist.
